# EUROPÄISCHE PATENTANMELDUNG

(11) **EP 1 521 088 A2**
(43) Veröffentlichungstag der Anmeldung: **06.04.2005**
(21) Anmeldenummer: 04020831.6
(22) Anmeldetag: 02.09.2004
(51) Int. Cl.: G01R 1/04

(54) **Zählerplatz für wenigstens einen Stromzähler**

(30) Priorität: 04.10.2003 DE 20315263 U
(71) Anmelder: ABB PATENT GmbH, 68526 Ladenburg (DE)
(72) Erfinder: Roth, Michael, 77886 Lauf (DE)
(74) Vertreter: Miller, Toivo

(57) **Zusammenfassung**

Die Erfindung betrifft eine Zählerplatzanordnung für wenigstens einen Stromzähler, mit einer Zugangs- und einer Abgangshauptklemmenanordnung, mit einer der Anzahl der Stromzähler entsprechenden Anzahl von Stromzählerklemmenanordnungen, mit denen Anschlussstifte am Stromzähler beim Einsetzen des Stromzählers kontaktierbar sind, und mit einer internen Verdrahtung. Die Verdrahtung ist durch Stromschienenanordnungen (30, 31, 32 und 33; 70) gebildet, die für jede Phase eine Stromschiene umfasst, die in einem die Stromschienen der drei Phasen aufnehmenden Isoliergehäuse (50) eingesetzt sind und Anschlussfahnen (62, 63 und 64) aufweisen, die in daran angepasste Stecköffnungen (72, 73 und 74) einsetzbar sind.

## Beschreibung

Die Erfindung betrifft eine Zählerplatz gemäß dem Oberbegriff des Anspruches 1.

Zählerplätze der eingangs genannten Art besitzen wenigstens einen Halterungsplatz für jeweils einen Stromzähler, wobei der Stromzähler auf seiner Befestigungsseite Anschlussstifte aufweist, mit denen er in eine Stromzählerklemmenanordnung eingefügt werden kann. Die elektrische Zuführung und elektrische Abführung erfolgt über Zugangs- und Abgangshauptklemmenanordnungen, in denen Zugangs- bzw. Abgangskabel festgeklemmt werden; die elektrische Verbindung zwischen dem Zugangs- und Abgangshauptklemmenanordnungen erfolgt über eine Verdrahtung, die mit konventionellen Leitungen, also mit flexiblen Leitungen vorgenommen wird. Komplett verdrahtete Zählerplätze werden an einem besonderen Ort, separaten Arbeitsplatz gefertigt, wobei die Leitungen hinter der Zählertragplatte mit zusätzlichen Kabelkanälen oder Kabelhaltern festgelegt sind.

Derartige Zählerplätze sind einer automatischen Fertigung kaum zugänglich; der Montageaufwand ist hoch und wegen des zusätzlichen, separaten Arbeitsplatzes für die Verdrahtung sind derartige Zählerplätze kostenintensiv.

Aufgabe der Erfindung ist es, einen Zählerplatz der eingangs genannte Art zu schaffen, der einer vereinfachten und gegebenenfalls auch automatischen Fertigung zugänglich ist, so dass die Kosten reduziert werden können.

Diese Aufgabe wird erfindungsgemäß durch die Merkmale des Anspruches 1 gelöst.

Erfindungsgemäß also erfolgt die Verdrahtung mittels Stromschienen, die in ein Isoliergehäuse eingesetzt sind und Anschlussfahnen aufweisen, die in entsprechende Stecköffnungen der Stromzählerklemmenanordnungen steckbar sind. Ein Isoliergehäuse nimmt dann alle Phasen auf.

Durch die Verwendung von Stromschienen anstatt flexibler Kabel oder flexibler Leitungen ist die Herstellung der Verdrahtung automatisierbar, indem entsprechende Flachbandleiter verwendet und zur Bildung von den Anschlussfahnen gestanzt werden können. Die Isoliergehäuse, in die die einzelnen Stromschienen einlegbar sind, sind ähnlich den Stromsammelschienen zur phasenweisen Verbindung von Installationsschaltgeräten, beispielsweise Leitungsschutzschaltern, in dem sich innerhalb des Isoliergehäuses durch sich längserstreckende Zwischenwände Kammern gebildet sind, in die die Stromschienen eingesetzt werden.

Damit die Stromschienen mit dem Isoliergehäuse auch eingebaut werden können, besitzen die Stromzählerklemmenanordnungen auf der dem Zähler abgewandten Seite geeignete Öffnungen für die Anschlussfahnen.

Weitere vorteilhafte Ausgestaltungen der Erfindung sind weiteren Unteransprüchen zu entnehmen.

Anhand der Zeichnung, in der ein Ausführungsbeispiel der Erfindung dargestellt ist, sollen die Erfindung sowie weitere vorteilhafte Ausgestaltungen und Verbesserungen der Erfindung näher erläutert und beschrieben werden.

### Es zeigen:

- Fig. 1: eine Frontansicht einer Zählertragplatte mit zwei Zählerplätzen,
- Fig. 2: eine vergrößerte Ansicht des Bereiches groß 2 der Fig. 1,
- Fig. 3: eine Rückansicht der Tragplatte gemäß Fig. 1,
- Fig. 4: eine vergrößerte Darstellung des Kreisbereiches IV und
- Fig. 5: eine perspektivische Teilansicht einer Stromschienenanordnung.

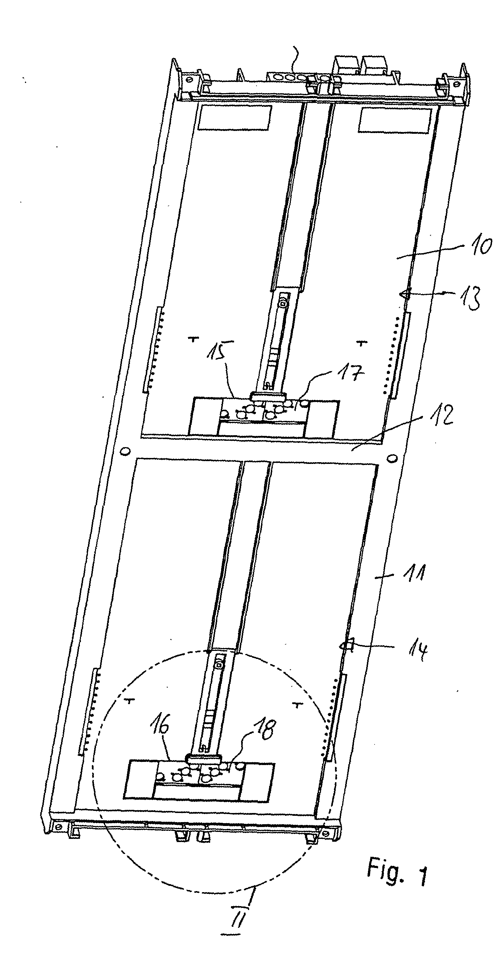

Eine Zählertragplatte 10, wie sie in der Fig. 1 dargestellt ist, besitzt einen Rahmen 11, der langgestreckt rechteckig ausgebildet ist und der durch einen horizontal verlaufenden Quersteg 12 in zwei Rahmenabschnitte 13 und 14 unterteilt ist, so dass zwei Stromzähler (nicht dargestellt) auf der Zählertragplatte 10 befestigt bzw. angeschlossen werden können.

Wie die Befestigung eines Zählers auf der Zählertragplatte 10 vorgenommen wird, wie die Zählertragplatte dann in einer Installationsverteilung untergebracht ist bzw. eingebaut ist, ist nicht Gegenstand der Erfindung.

In den Bereichen, in denen ein Stromzähler eingesetzt werden soll, ist in einer Ausnehmung 15 bzw. 16 eine Zählerklemmenanordnung 17 bzw. 18 eingesetzt, die ortsfeste Steckerbuchsen 19, 20 und 21 für jede Phase auf der Zugangsseite des Stromzählers und Steckerbuchsen 22, 23 und 24 auf der Abgangsseite des Stromzählers aufweist. Zusätzlich sind auf der Zugangsseite noch Kontaktbuchsen 24 und 25 für den Neutralleiter vorgesehen. Zu diesem Zweck ist auf der Rückseite jedes Stromzählers eine der Anzahl der Phasen mit dem N-Leiter entsprechende Anzahl von Steckerstiften angeordnet, so dass die eine Hälfte der Steckerstifte als Eingangssteckerstifte und die andere Hälfte der Steckerstifte als Ausgangssteckerstifte des Zählers dienen. Wie die Steckerstifte am Stromzähler in der Stromzählerklemmenanordnung angeschlossen sind und wie darüber hinaus auch der Stromzähler an der Zählertragplatte befestigt ist, soll hier nicht weiter ausgeführt werden.

Die Stromzählerklemmenanordnung 18 ist im Bereich des unteren Querrahmensteges 26 angeordnet und die Stromzählerklemmenanordnung 17 im Bereich des Quersteges 12; darüber hinaus ist die Stromzählerklemmenanordnung 17 identisch zu der mit der Bezugsziffer 18.

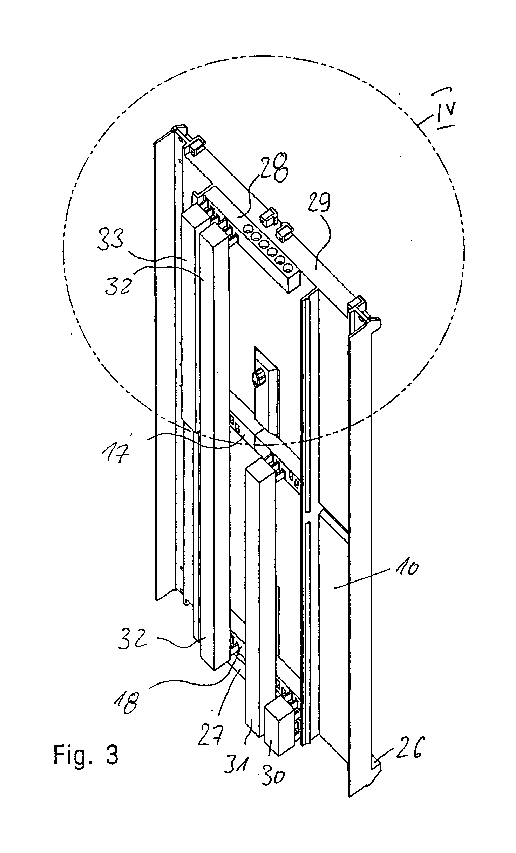

Die Fig. 3 zeigt nun die Stromzählertragplatte auf ihrer Rückseite. Auf der Rückseite sind an der Tragplatte 10 eine Zugangsklemmenanordnung 27 im Bereich des unteren Quersteges 26 und eine Abgangsklemmenanordnung 28 am oberen Quersteg 29 des Rahmens 11 angeordnet.

Oberhalb der Zugangshauptklemmenanordnung 27 sind die untere Stromzählerklemmenanordnung 18 und oberhalb des in der Fig. 3 nicht sichtbaren Quersteges 12 die Stromzählerklemmenanordnung 17 angeordnet.

Zur Verbindung bzw. zur Verdrahtung sind nun mehrere vorgefertigte Stromschienenanordnungen 30, 31, 32 und 33 vorgesehen.

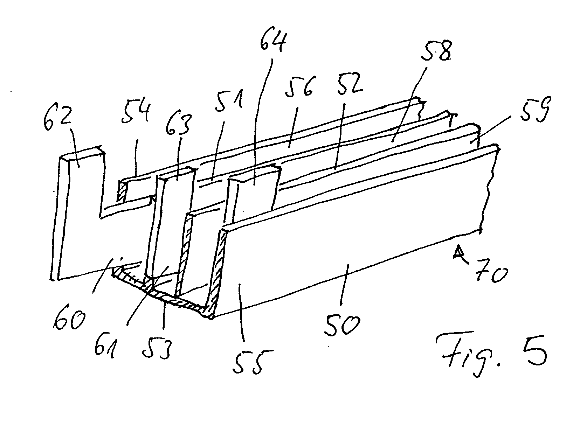

Wie die einzelnen Stromschienenanordnungen aufgebaut sind, ist der Fig. 5 zu entnehmen. Innerhalb eines Gehäuses 50, welches U-förmig mit einem Bodensteg 53 und zwei Schenkeln 54 und 55 ausgebildet ist, verlaufen Trennwände 51 und 52, wobei zwischen den Schenkeln 54 und der Trennwand 51 ein erster Stromschienenaufnahmeraum 56, zwischen den Trennwänden 51 und 52 ein zweiter Stromschienenaufnahmeraum 57 und zwischen der Trennwand 52 und dem Schenkel 55 ein dritter Stromschienenaufnahmeraum 59 gebildet ist, in die Stromschienen 60 und 61 eingelegt sind; diese Stromschienen besitzen an ihren Enden senkrecht dazu vorspringende Anschlussfahnen 62 und 63. In den Aufnahmeraum 59 ist ebenfalls eine Stromschiene eingesetzt, von der lediglich die Anschlussfahne 64 sichtbar ist. Die gesamte Anordnung trage beispielsweise die Bezugsziffer 70, die dann der Stromschienenanordnung 33 entspricht. Die Trennwände 51, 52 sind am Bodensteg 53 parallel zu den Schenkeln 54, 55 angeformt.

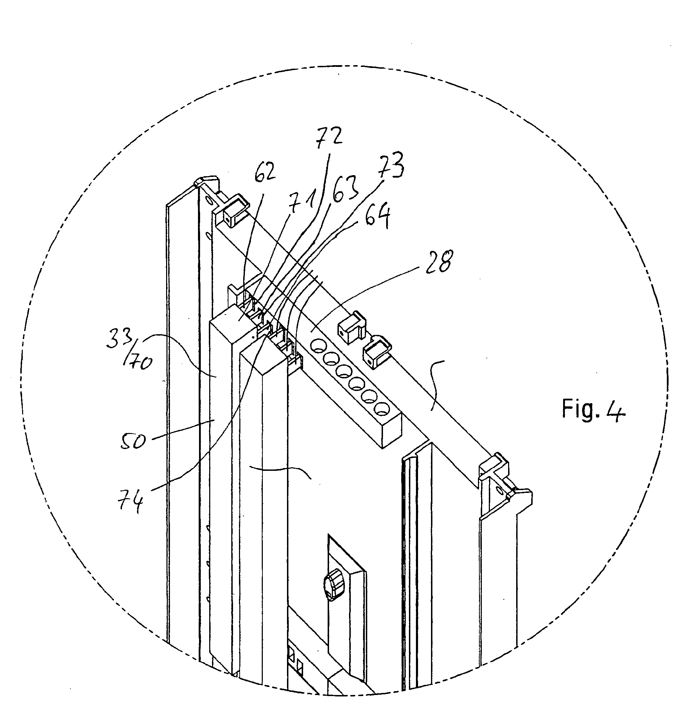

Man erkennt in der Fig. 4 die Stromschienenanordnungen 33/70, mit dem Isoliergehäuse 50, welches an den Enden mittels senkrecht zu den Schenkeln 54 und 55 verlaufender Abschlusswandungen 71 verschlossen ist. Die Anschlussfahnen 62, 63 und 64 greifen in entsprechend ausgebildete und daran angepasste Öffnungen 72, 73 und 74 ein, wodurch eine elektrisch leitende Verbindung zwischen den Stromschienen 60, 61 mit den Anschlussfahnen 62, 63 und 64 an die Abgangshauptklemmenanordnung 28 erreicht ist.

Wie aus Fig. 5 ersichtlich, sind die Anschlussfahnen 62, 63 und 64 in Längsrichtung der Schienenanordnung 33/70 versetzt angeordnet, was auch bedeutet, dass die Aufnahmeöffnungen 72, 73 und 74 in entsprechender Weise versetzt angeordnet sind.

Die Stromschienenanordnung 33/70 der Fig. 5 verbindet die Zählerklemmenanordnung 17 mit der Abgangshauptklemmenanordnung 28.

Die Stromschienenanordnung 30 ist in gleicher Weise aufgebaut wie die Stromzähleranordnung 33/70. Da hier nur der Abstand zwischen der Zugangshauptklemmenanordnung und der unteren Stromzählerklemmenanordnung 18 zu überbrücken ist, ist die Stromschienenanordnung entsprechend kurz; da mittels der Stromschienenanordnung 31 der Abstand zwischen der Zugangsklemmenanordnung 27 und der Zählerklemmenanordnung 17 zu überbrücken ist, besitzt diese Stromschienenanordnung eine daran angepasste Länge, was auch für die Stromschienenanordnung 32 gilt, die die Distanz zwischen der Zählerklemmenanordnung 18 und der Abgangshauptklemmenanordnung 28 zu überbrücken hat.

### Die Wirkungsweise ist nun wie folgt:

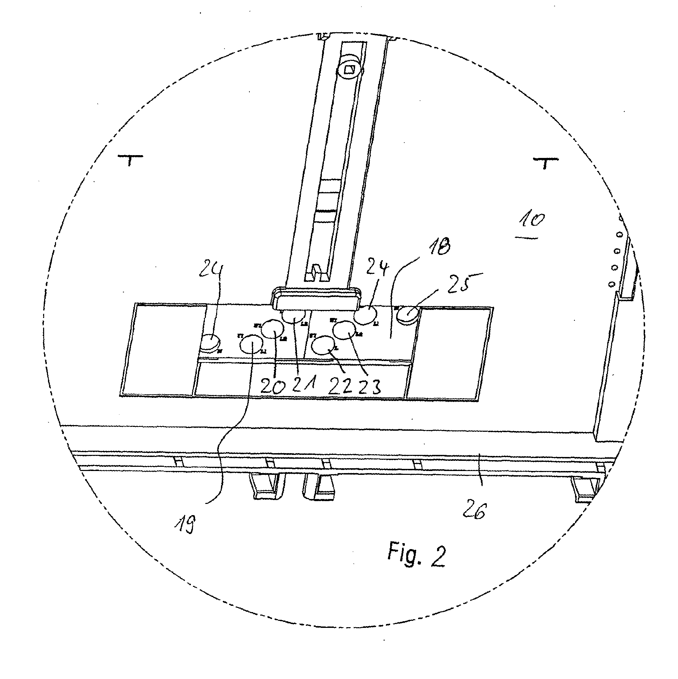

Es sei angenommen, dass sowohl mit der unteren Zählerklemmenanordnung 18 als auch mit der oberen Klemmenanordnung 17 ein Stromzähler verbunden ist. Mittels der Stromschienenanordnung 30 wird Energie der unteren Stromzählerklemmenanordnung 18 zugeführt; über die in Fig. 2 angegebenen Steckbuchsen 19, 20 und 21 fließt der Strom in den Zähler hinein und über die Klemmbuchsen 22, 23 und 24 aus diesem wieder heraus und über die Stromschienenanordnung 32 wird die Energie zu der Abgangshauptklemmenanordnung 28 geleitet.

Für den Stromzähler, der an der Stromzählerklemmenanordnung 17 angeschlossen ist, erfolgt die Energiezufuhr über die die Zugangshauptklemmenanordnung 27 mit der Stromzählerklemmenanordnung 17 verbindenden Stromschienenanordnung 31 und über die Stromschienenanordnung 33 wird der Ausgang des Stromzählers mit der Abgangshauptklemmenanordnung verbunden.

Wenn lediglich ein Stromzähler an der unteren Stromzählerklemmenanordnung 18 angeschlossen werden soll, dann benötigt man hierbei lediglich die Stromschienenanordnung 30 und die Stromschienenanordnung 32. Umgekehrt, wenn der Stromzähler an die Stromzählerklemmenanordnung 17 angeschlossen werden soll, benötigt man die Stromschienenanordnungen 31 und 33/70.

Die besonderen Vorteile der Erfindung bestehen darin, dass das Isoliergehäuse 70 auf einfache Weise im Extradierverfahren oder gegebenenfalls im Spritzgießverfahren hergestellt werden kann; die Stromschienen können ausgestanzt sein; darüber hinaus können die Stromschienen auch in den Kammern 56, 58 und 59 verrastet sein, wie dies beispielsweise bei Sammelschienenanordnungen der Fall ist, die zur phasenweisen Verbindung von Leitungsschutzschaltern innerhalb einer Hausinstallationsverteilung, die sich an die Stromzähleranordnung anschließt, der Fall ist. Besondere Verlegearbeiten für flexible Kabel sind nicht mehr erforderlich. Damit wird eine deutliche Kostenreduktion der Herstellung einer solchen Zählerplatzanordnung erzielt.

Ergänzend sei ausgeführt, dass "unten" und "oben" Ortsangaben des in einer Verteilung montierten Zählerplatzes sind.

## Patentansprüche

1. Zählerplatzanordnung für wenigstens einen Stromzähler, mit einer Zugangsund einer Abgangshauptklemmenanordnung, mit einer der Anzahl der Stromzähler entsprechenden Anzahl von Stromzählerklemmenanordnungen, mit denen Anschtussstifte am Stromzähler beim Einsetzen des Stromzählers kontaktierbar sind, und mit einer internen Verdrahtung, **dadurch gekennzeichnet, dass** die Verdrahtung durch Stromschienenanordnungen (30, 31, 32 und 33; 70) gebildet ist, die für jede Phase eine Stromschiene umfasst, die in einem die Stromschienen der drei Phasen aufnehmenden Isoliergehäuse (50) eingesetzt sind und Anschlussfahnen (62, 63 und 64) aufweisen, die in daran angepasste Stecköffnungen (72, 73 und 74) einsetzbar sind.

2. Zählerplatzanordnung nach Anspruch 1, **dadurch gekennzeichnet, dass** die Stromzählerklemmenanordnung auf der dem Stromzähler abgewandten Seite die Öffnungen (72, 73, 74) für die Anschlussfahnen (62, 63, 64) aufweist.

3. Zählerplatzanordnung nach einem der vorherigen Ansprüche, **dadurch gekennzeichnet, dass** die untere Stromzähleranschlussklemmenanordnung oberhalb der unteren Zugangsklemmenanordnung angeordnet ist.

4. Zählerplatzanordnung nach einem der vorherigen Ansprüche, **dadurch gekennzeichnet, dass** eine erste Stromschienenanordnung (30) eine dem Abstand der Zugangshauptklemmenanordnung (27) und der unteren Stromzählerklemmenanordnung (18) entsprechende Länge und eine zweite Stromschienenanordnung (32) eine dem Abstand der Zugangshauptklemmenanordnung (27) und der Abgangshauptklemmenanordnung (28) entsprechende Länge aufweist.

5. Zählerplatzanordnung nach einem der vorherigen Ansprüche, mit zwei übereinander liegenden Zählerplätzen, **dadurch gekennzeichnet, dass** eine dritte Stromschienenanordnung (31) eine Länge besitzt, die dem Abstand von der Zusatzklemmenanordnung (27) und der Stromzählerklemmenanordnung (17) des oberen Zählerplatzes entspricht und eine vierte Stromschienenanordnung (33) aufweist, deren Länge dem Abstand der Stromzählerklemmenanordnung (17) des oberen Zählerplatzes und der Abgangshauptklemmenanordnung (28) entspricht.

6. Zählerplatzanordnung nach einem der vorherigen Ansprüche, **dadurch gekennzeichnet, dass** jede Stromschienenanordnung ein langgestrecktes ausgebildetes U-förmiges Gehäuse aufweist, in dem längsverlaufende Stromschienenaufnahmekammern (56, 58 und 59) durch Trennwände (51, 52) gebildet sind.
